Europäisches Patentamt

European Patent Office

Office européen des brevets

(11) Veröffentlichungsnummer: **0 209 195 B1**

(12) **EUROPÄISCHE PATENTSCHRIFT**

(45) Veröffentlichungstag der Patentschrift: **01.04.92**

(21) Anmeldenummer: **86201223.4**

(22) Anmeldetag: **14.07.86**

(51) Int. Cl.⁵: **G11B 25/06**, G11B 33/14,
H05K 9/00, G11B 33/12

(54) Aufzeichnungs- und/oder Wiedergabegerät.

(30) Priorität: **15.07.85 AT 2090/85**

(43) Veröffentlichungstag der Anmeldung:
**21.01.87 Patentblatt 87/04**

(45) Bekanntmachung des Hinweises auf die
Patenterteilung:
**01.04.92 Patentblatt 92/14**

(84) Benannte Vertragsstaaten:
**DE FR GB**

(56) Entgegenhaltungen:
**BE-A- 657 917**
**GB-A- 2 148 063**
**GB-A- 2 149 955**

(73) Patentinhaber: **N.V. Philips' Gloeilampenfabrieken
Groenewoudseweg 1
NL-5621 BA Eindhoven(NL)**

(72) Erfinder: **Schild, Josef
INT. OCTROOIBUREAU B.V. Prof. Holstlaan 6
NL-5656 AA Eindhoven(NL)**
Erfinder: **Schramel, Johannes
INT. OCTROOIBUREAU B.V. Prof. Holstlaan 6
NL-5656 AA Eindhoven(NL)**

(74) Vertreter: **Smit, Frederik Jan et al
INTERNATIONAAL OCTROOIBUREAU B.V.
Prof. Holstlaan 6
NL-5656 AA Eindhoven(NL)**

## Beschreibung

Die Erfindung betrifft ein Aufzeichnungs- und/oder Wiedergabegerät für einen bandförmigen, magnetisierbaren Aufzeichnungsträger, der schraubenlinienförmig zumindest über einen Teil der Mantelfläche einer auf einem elektrisch leitfähigen Chassis angeordneten zylindrischen Abtasteinheit schlingbar ist, die mindestens einen rotierend antreibbaren Magnetkopf aufweist, der über ein abgeschirmtes Kabel mit einem in einer elektrisch leitfähigen, einen Boden- und Deckelteil aufweisenden Abschirmdose untergebrachten Verstärker zusammenwirkt, und von einer von Chassis und streifenförmigen, elektrisch leitfähigen Wänden gebildeten Abschirmung manschettenartig umgeben ist. Sowohl der Magnetkopf als auch der Verstärker und auch das zwischen denselben verlaufende Kabel sind sehr empfindlich auf Störstrahlungen in Form von elektromagnetischen Feldern, da in diesem elektrischen Bereich des Gerätes elektrische Nutzsignale mit relativ kleiner Amplitude verarbeitet werden. Um solche Störstrahlungen von den in Rede stehenden Geräteteilen fernzuhalten, ist es von im Handel befindlichen derartigen Geräten bekannt, einerseits die Abtasteinheit mit einer manschettenartigen Abschirmung zu umgeben und andererseits den Verstärker in einer separaten Abschirmdose unterzubringen, die neben der Abtasteinheit am Chassis angeordnet ist, wobei dann für die elektrische Verbindung von der Abtasteinheit zur Abschirmdose ein abgeschirmtes Kabel verwendet wird. Ein derartiger Aufbau erfordert relativ viel Platz und ist auch durch die beiden separaten Abschirmungen relativ aufwendig, wobei ausserdem noch das zwischen der Abtasteinheit und dem Verstärker verlaufende Kabel relativ lang und daher trotz seiner Abschirmung empfindlich für Störsignale ist.

Die Erfindung hat sich zum Ziel gesetzt, eine Abschirmung für die Abtasteinheit und den Verstärker zu schaffen, die möglichst raumsparend und möglichst einfach aufgebaut ist. Bei einem Gerät der eingangs angeführten Gattung ist hierzu erfindungsgemäss vorgesehen, dass die Abschirmdose für den Verstärker und die manschettenartige Abschirmung für die Abtasteinheit zu einer Baueinheit zusammengefasst sind, bei der eine Wand der Abschirmdose und eine Wand der manschettenartigen Abschirmung durch ein gemeinsames Wandteil gebildet ist. Auf diese Weise ist erreicht, dass die beiden abzuschirmenden Teile, nämlich die Abtasteinheit und der Verstär ker, räumlich eng nebeneinander liegen und die gesamte Abschirmung für beide Teile, durch die Doppelausnützung eines Wandteiles, einfach und kostengünstig aufgebaut ist.

Als sehr vorteilhaft hat sich erwiesen, wenn das gemeinsame Wandteil im Bereich des dem Chassis gegenüberliegenden freien Endes der Abtasteinheit vorgesehen ist und dabei im wesentlichen parallel zu der Endfläche der Abtasteinheit verläuft. Auf diese Weise wird der unmittelbar am freien Ende der Abtasteinheit befindliche, vielfach ungenützte Raum zur Unterbringung des Verstärkers ausgenützt, wodurch eine besonders kompakte Bauweise erhalten wird.

In diesem Zusammenhang hat sich weiters als vorteilhaft erwiesen, wenn das gemeinsame Wandteil an einer an ihn anschliessenden Wand der manschettenartigen Abschirmung verschwenkbar angeordnet ist. Auf diese Weise ist die Abtasteinheit einfach zugänglich, so dass beispielsweise im Zuge der Montage des Gerätes an ihr Einstellarbeiten vorgenommen werden können, ohne dass dabei der Verstärker mit seiner Abschirmung hinderlich im Wege ist.

Weiters hat sich als vorteilhaft erwiesen, wenn der Abtasteinheit axial gegenüberliegend eine Öffnung im gemeinsamen Wandteil vorgesehen ist, durch welche mindestens das freie Ende der Welle, über welche der Magnetkopf rotierend antreibbar ist, hindurchragt, und an der von der Abtasteinheit abgewandten Seite des gemeinsamen Wandteiles im Bereich der in ihm vorgesehenen Öffnung eine elektrisch leitfähige Blattfeder angeordnet und mit ihm elektrisch leitfähig verbunden ist. Welche mit ihrem freien Ende am freien Ende der Welle federnd anliegt. Hierdurch wird eine besonders kompakte Bauweise erhalten, da die Abschirmung unmittelbar im Bereich des freien Endes der Abtasteinheit verlaufen kann, wobei ausserdem noch die Möglichkeit geschaffen ist, eine zusätzliche elektrisch leitfähige Verbindung zur Abtasteinheit herzustellen, um in bekannter Weise elektrostatische Aufladungen zu vermeiden.

Im Hinblick auf einen einfachen Aufbau hat sich auch als vorteilhaft erwiesen, wenn der Verstärker an der von der Abtasteinheit abgewandten Seite des gemeinsamen Wandteiles angeordnet ist, wobei dieses gemeinsame Wandteil als Bodenteil der Abschirmdose für den Verstärker ausgebildet ist, auf den ihr Deckelteil aufsetzbar ist. Auf diese Weise ist erreicht, dass auch der Verstärker einfach zugänglich ist.

Weiters hat sich als vorteilhaft erwiesen, wenn an einer an das gemeinsame Wandteil anschliessenden Wand der manschettenartigen Abschirmung ein im wesentlichen parallel zur Abtasteinheit verlaufender Kanal angeformt ist, durch den das abgeschirmte Kabel hindurchgeführt ist, über welches der Magnetkopf mit dem Verstärker zusammenwirkt. Hierdurch wird auf einfache Weise eine zusätzliche Abschirmung für das abgeschirmte Kabel und damit eine weitere Herabsetzung von dessen Störstrahlungsempfindlichkeit erreicht.

Die Erfindung wird im folgenden anhand der Zeichnung, in der ein Ausführungsbeispiel der Erfindung dargestellt ist, auf das sie aber nicht beschränkt sein soll, näher erläutert.

Fig. 1 zeigt teilweise im Schnitt und in Seitenansicht eine abgeschirmte Abtasteinheit und einen abgeschirmten Verstärker eines Aufzeichnungs- und/oder Wiedergabegerätes.

Fig. 2 zeigt einen Ausschnitt der Abtasteinheit und des Verstärkers nach Fig. 1 mit einem hochgeklappten Teil der Abschirmung.

Fig 3 zeigt einen Schnitt nach der Linie III-III in Fig. 1.

Fig. 4 zeigt einen Schnitt nach der Linie IV-IV in den Figuren 1 und 2.

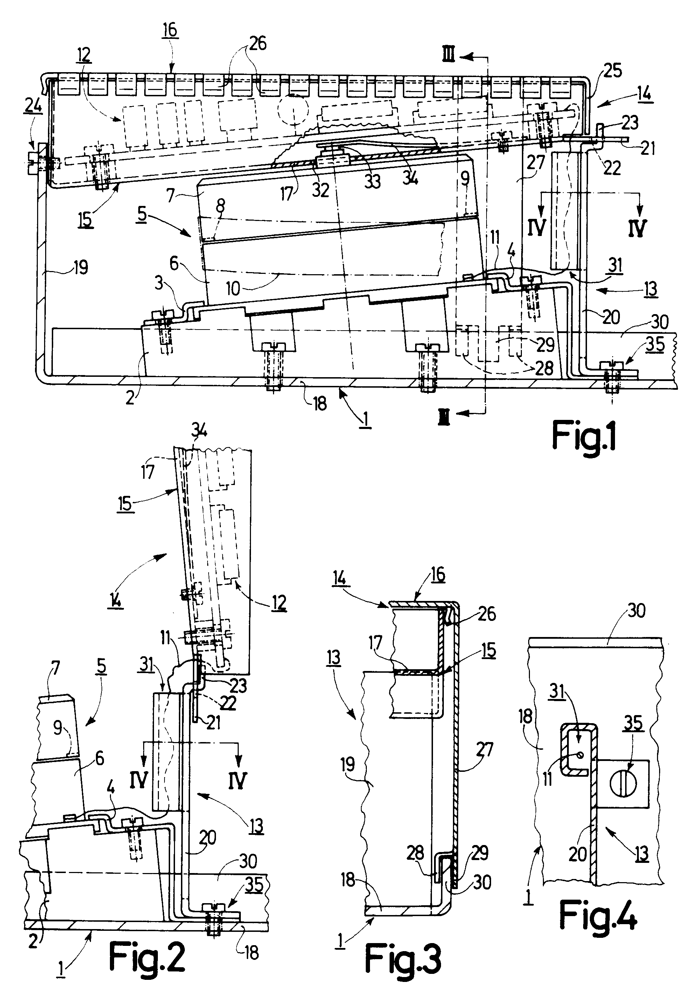

In Fig. 1 ist mit 1 das Chassis eines Aufzeichnungs-und/oder Wiedergabegerätes für einen bandförmigen, magnetisierbaren Aufzeichnungsträger bezeichnet, das aus einem elektrisch leitfähigen Material besteht. Auf diesem Chassis 1 ist ein hohlzylindrischer, beispielsweise aus Kunststoff bestehender Träger 2 befestigt, auf dem mit Klammern 3 und 4 eine in üblicher Weise gegenüber dem Chassis 1 geneigt verlaufende zylindrische Abtasteinheit 5 angebracht ist. Diese Abtasteinheit 5 besteht aus einem stillstehenden Trommelteil 6 und einem zu demselben koaxialen, rotierend antreibbaren Trommelteil 7, zwischen welchen ein Spalt gebildet ist, in dessen Bereich am Trommelteil 7 beispielsweise zwei einander diametral gegenüberliegende Magnetköpfe 8 und 9 angeordnet sind. Der Motor zum Antreiben des Trommelteiles 7 kann im stillstehenden Trommelteil 6 untergebracht oder an diesen angeflanscht sein. Über zumindest einen Teil der Mantelfläche dieser Abtasteinheit 5 ist ein bandförmiger, magnetisierbarer Aufzeichnungsträger 10 schraubenlinienförmig schlingbar, wie dies mit strichpunktierten Linien angedeutet ist. In bekannter Weise können mit den Magnetköpfen 8 und 9 einer solchen Abtasteinheit 5 elektrische Nutzsignale, wie beispielsweise Videosignale, in schräg verlaufenden Spuren am Aufzeichnungträger 10 aufgezeichnet beziehungsweise vom Aufzeichnungträger wiedergegeben werden. Hierzu stehen die Magnetköpfe 8 und 9 über ein Kabel 11 mit einem Verstärker 12 in Verbindung. Sowohl die Magnetköpfe 8 und 9 als auch der Verstärker 12 und auch das zwischen denselben verlaufende Kabel 11 sind sehr empfindlich auf Störstrahlungen in Form von elektromagnetischen Feldern, da in diesem elektrischen Bereich des Gerätes elektrische Nutzsignale mit relativ kleiner Amplitude verarbeitet werden. Um solche Störstrahlungen von den in Rede stehenden Geräteteilen fernzuhalten, wird in bekannter Weise einerseits die Absteinheit 5 mit einer manschettenartigen Abschirmung 13 umgeben und andererseits der Verstärker 12 in einer Abschirmdose 14 untergebracht und für die Verbindung zwischen denselben ein abgeschirmtes Kabel 11 verwendet. Die Abschirmdose 14 besteht dabei aus einem shachtelförmigen Bodenteil 15, der mit einem abnehmbaren Deckelteil 16 verschliessbar ist.

Um nun eine möglichst raumsparende und einfach aufgebaute Abschirmung für die Abtasteinheit 5 und den Verstärker 12 zu schaffen, ist vorgesehen, dass die Abschirmdose 14 für den Verstärker 12 und die manschettenartige Abschirmung 13 für die Abtasteinheit 5 zu einer Baueinheit zusammengefasst sind, bei der eine Wand der Abschirmdose und eine Wand der manschettenartigen Abschirmung durch einen gemeinsamen Wandteil gebildet ist. Wie aus Fig. 1 ersichtlich ist, besteht beim vorliegenden Ausführungsbeispiel der gemeinsame Wandteil aus der streifenförmigen Bodenwand 17 des schachtelförmigen Bodenteiles 15, die somit auch eine Wand der mansch e ttenartigen Abschirmung 13 bildet. Hierbei ist die Abschirmdose 14 im Bereich des dem Chassis 1 gegenüberliegenden freien Endes der Abtasteinheit 5 angeordnet, wobei ihre Bodenwand 17 im wesentlichen parallel zu der Endfläche der Abtasteinheit 5 verläuft, wodurch eine gut Raumausnützung erhalten wird. Zur Vervollständigung der manschettenartigen Abschirmung 13 weist das Chassis 1 eine von seiner Basisplatte 18 abgewinkelte, streifenförmige Wand 19 auf, wobei weiters mit der Basisplatte 18 des Chassis 1 eine im wesentlichen parallel zur Wand 19 verlaufende, separate, streifenförmige Wand 20 verbunden ist. Auf diese Wände 19 und 20 ist die Abschirmdose 14 aufgesetzt. Auf diese Weise umgeben die Basisplatte 18 des Chassis 1, dessen abgewinkelte Wand 19, die Bodenwand 17 der Abschirmdose 14 und die Wand 20 die Abtasteinheit 5 manschettenartig und bilden so die Abschirmung 13 für dieselbe.

Die Verbindung der Abschirmdose 14 mit den streifenförmigen Wänden 19 und 20 erfolgt beim vorliegenden Ausführungsbeispiel in der Weise, dass die Abschirmdose 14 hochgeschwenkt werden kann, so dass die Abtasteinheit 5 zugänglich wird, was beispielsweise im Zuge der Montage des Gerätes vorteilhaft ist, um Einstellarbeiten an der Abtasteinheit 5 vornehmen zu können.

Hierzu ist am Bodenteil 15, der Wand 20 benachbart, eine nach aussen vorspringende Leiste 21 vorgesehen, die mit mehreren, hintereinander liegenden, parallel zur Wand 20 verlaufenden Schlitzen 22 versehen ist. Korrespondierend zu diesen Schlitzen 22 sind an der Wand 20 abgewinkelte Lappen 23 vorgesehen, so dass die Abschirmdose 14 mit den Schlitzen 22 auf die Lappen 23 aufgesetzt werden kann. Auf diese Weise kann die Abschirmdose 14 oder nur ihr Bodenteil 15 hochgeschwenkt werden, wie dies Fig. 2 zeigt. Ist die Abschirmdose 14 zur Abtasteinheit 5 heruntergeschwenkt, so kann sie dort in ihrer Lage gesichert werden. Diese Lagesicherung kann beispielsweise durch ein Verschränken der Lappen 23 und eine Schraubverbindung 24 zwischen der Wand 19 und dem Bodenteil 15 der Abschirmdose 14 geschehen. Für eine derartige Schwenkverbindung und Lagesicherung stehen natürlich im Rahmen des diesbezuglichen Standes der Technik auch noch andere Massnahmen zur Verfügung. Damit die Abschirmdose 14 im Bereich der vom Bodenteil 15 nach aussen vorspringenden Leiste 21 nicht offen ist, ist am Deckelteil 16 ein abgewinkelter Wandabschnitt 25 vorgesehen, der somit die fehlende Seitenwand des Bodenteiles 15 ersetzt. Zur lösbaren Halterung des Deckelteiles 16 am Bodenteil 15 ist an ihm in üblicher Weise eine Reihe von Lappen 26 vorgesehen, die den Bodenteil 15 etwas federnd umgreifen. Um auch zwischen dem Deckelteil 16 und dem Chassis 1 eine Verbindung herzustellen, weist er einen Steg 27 auf, der an seinem freien Ende zwei abgewinkelte Lappen 23 und einen zwischen denselben liegenden geraden Lappen 29 trägt, die eine von der Basisplatte 18 des Chassis 1 abgewinkelte Leiste 30 abwechselnd seitlich umfassen, wie dies auch Fig. 3 erkennen lässt. Der Verstärker 12 ist an der von der Abtasteinheit 5 abgewandten Seite des gemeinsamen Wandteiles, nämlich der Bodenwand 17 des schachtelförmigen Bodenteiles 15 angeordnet, wodurch er nach Abnahme des Deckelteiles 16 sehr gut zugänglich ist.

Durch eine derartige Doppelausnützung eines Wandteiles für beide Abschirmungen wird ausserdem erreicht, dass die beiden abzuschirmenden Bauteile, nämlich die Abtasteinheit 5 und der Verstärker 12, räumlich eng nebeneinander liegen. Dies bietet nicht nur den Vorteil, dass die Abschirmungen an sich in ihrem Aufbau einfach sind, sondern dass auch die durch das abgeschirmte Kabel 11 erfolgende elektrische Verbindung zwischen der Abtasteinheit 5 und dem Berstärker 12 sehr kurz sein kann, wodurch sie für Störsignale weniger empfindlich ist. In diesem Zusammenhang ist beim vorliegenden Ausführungsbeispiel weiters vorgesehen, dass an der Wand 20 ein im wesentlichen parallel zur Abtasteinheit 5 verlaufender Kanal 31 angeformt ist, durch den das abgeschirmte Kabel 11 hindurchgeführt ist, wodurch es zusätzlich noch gegen Störstrahlungen geschützt wird. Wie insbesondere Fig. 4 erkennen lässt, kann ein solcher Kanal 31 einfach durch eine mehrfache Abwinkelung eines Abschnittes der Wand 20 gebildet werden.

Wie Fig. 1 zeigt, ist der Abtasteinheit 5 axial gegenüberliegend im durch die Bodenwand 17 gebildeten, gemeinsamen Wandteil eine Öffnung 32 vorgesehen, durch welche das freie Ende einer Welle 33, über welche der die Magnetköpfe 8 und 9 tragende Trommelteil 7 rotierend antreibbar ist, hindurchragt. Weiters ist an der von der Abtasteinheit 5 abgewandten Seite des den gemeinsamen Wandteil bildenden Bodenteiles 17 im Bereich der in ihm vorgesehenen Öffnung 32 eine elektrisch leitfähige Blattfeder 34 angeordnet und mit ihm elektrisch leitfähig verbunden, welche mit ihrem freien Ende am freien Ende der Welle 33 federnd anliegt. Auf diese Weise wird eine besonders kompakte Bauweise erhalten, da die den gemeinsamen Wandteil bildende Bodenwand 17 unmittelbar im Bereich des freien Endes der Abtasteinheit 5 verlaufen kann. Ausserdem gestaltet sich die Bildung der leitfähigen Verbindung zum freien Ende der Welle 33 der Abtasteinheit 5 mittels der Blattfeder 34 sehr einfach und sicher. In bekannter Weise sorgt eine derartige leitfähige Verbindung dafür, dass elektrostatische Aufladungen des rotierend antreibbaren Trommelteiles 7 der Abtasteinheit 5 vermieden werden. Um sicher zu gehen, dass auch elektrostatische Aufladungen des stillstehenden Trommelteiles 6 der Abtasteinheit 5 vermieden werden, ist die die Abtasteinheit 5 am Träger 2 festhaltende Klammer 4 bis zum Chassis 1 hin verlängert und gemeinsam mit der Wand 20 durch eine Schraubverbindung 35 an demselben befestigt.

Selbstverständlich ist noch eine Reihe von Abwandlungen des vorstehend beschriebenen Ausführungsbeispieles möglich, ohne dass dabei der Rahmen der Erfindung verlassen wird. So könnte beispielsweise anstelle der von der Basisplatte 18 des Chassis 1 abgewinkelten Wand 19 auch eine separate Wand vorgesehen sein, dies in analoger Weise zu Wand 20. Ebenso könnte die Abschirmdose 14 auch seitlich von der Abtasteinheit 5 angeordnet werden, dies anstelle einer der Wände 19 oder 20, wobei dann dem freien Ende der Abtasteinheit 5 gegenüberliegend eine separate Wand vorgesehen wird, um wieder die manschettenartige Abschirmung für die Abtasteinheit 5 zu vervollständigen. Weiters könnte auch der Deckelteil 16 der Abschirmdose 14 den den beiden Abschirmungen gemeinsamen Wandteil bilden, wobei dann der den Verstärker 12 enthaltende Bodenteil 15 sozusagen vom Deckelteil 16 abnehmbar wäre. Wesentlich ist, dass die Abschirmdose 14 für den Verstärker 12 und die manschettenartige Abschirmung 13 für die Abtasteinheit 5 zu einer Baueinheit zusammengefasst sind, bei der eine Wand der Abschirmdose und eine Wand der manschettenartigen Abschirmung durch einen gemeinsamen Wandteil gebildet ist.

**Patentansprüche**

1. Aufzeichnungs- und/oder Wiedergabegerät für einen bandförmigen, magnetisierbaren Aufzeichnungsträger (10), der schraubenlinienförmig zumindest über einen Teil der Mantelfläche einer auf einem elektrisch leitfähigen Chassis (1) angeordneten zylindrischen Abtasteinheit (5) schlingbar ist, die mindestens einen rotierend antreibbaren Magnetkopf (8,9) aufweist, der über ein abgeschirmtes Kabel (11) mit einem in einer elektrisch leitfähigen, einen Boden- und Deckelteil (15,16) aufweisenden Abschirmdose (14) untergebrachten Verstärker (12) zusammenwirkt, und von einer vom Chassis (1) und streifenförmigen, elektrisch leitfähigen Wänden gebildeten Abschirmung (13) manschettenartig umgeben ist, dadurch gekennzeichnet, dass die Abschirmdose (14) für den Verstärker (12) und die manschettenartige Abschirmung (13) für die Abtasteinheit (5) zu einer Baueinheit zusammengefasst sind, bei der eine Wand der Abschirmdose (14) und eine Wand der manschettenartigen Abschirmung (13) durch ein gemeinsames Wandteil (17) gebildet ist.

2. Gerät nach Anspruch 1, dadurch gekennzeichnet, dass das gemeinsame Wandteil (17) im Bereich des dem Chassis (1) gegenüberliegenden freien Endes der Abtasteinheit vorgesehen ist und dabei im wesentlichen parallel zur Endfläche der Abtasteinheit (5) verläuft.

3. Gerät nach Anspruch 2, dadurch gekennzeichnet, dass das gemeinsame Wandteil (17) an einer an ihn anschliessenden Wand (20) der manschettenartigen Abschirmung (13) verschwenkbar angeordnet ist.

4. Gerät nach Anspruch 2 oder 3, dadurch gekennzeichnet, dass der Abtasteinheit (5) axial gegenüberliegend eine Öffnung (32) im gemeinsamen Wandteil vorgesehen ist, durch welche mindestens das freie Ende der Welle (33), über welche der Magnetkopf (8,9) rotierend antreibbar ist, hindurchragt, und dass an der von der Abtasteinheit (5) abgewandten Seite des gemeinsamen Wandteiles (17) im Bereich der in ihm vorgesehenen Öffnung (32) eine elektrisch leitfähige Blattfeder (34) angeordnet und mit ihm elektrisch leitfähig verbunden ist, welche mit ihrem freien Ende am freien Ende der Welle (33) federnd anliegt.

5. Gerät nach einem der Ansprüche 2 bis 4, dadurch gekennzeichnet, dass der Verstärker (12) an der von der Abtasteinheit (5) abgewandten Seite des gemeinsamen Wandteiles (17) angeordnet ist, wobei dieses gemeinsame Wandteil (17) als Bodenteil der Abschirmdose (14) ausgebildet ist, auf den ihr Deckelteil (16) aufsetztbar ist.

6. Gerät nach einem der Ansprüche 2 bis 5, dadurch gekennzeichnet, dass an einer an das gemeinsame Wandteil (17) anschliessenden Wand (20) der manschettenartigen Abschirmung ein im wesentlichen parallel zur Abtasteinheit verlaufender Kanal (31) angeformt ist, durch den das abgeschirmte Kabel (11) hindurchgeführt ist, über welches der Magnetkopf (8,9) mit dem Verstärker (12) zusammenwirkt.

## Claims

1. A recording and/or reproducing apparatus for a magnetisable record carrier (10) in the form of a tape which can be wrapped along a helical path over at least a part of the circumferential surface of a cylindrical scanning unit (5) arranged on an electrically conductive chassis (1), which unit comprises at least one rotatable magnetic head (8,9) which cooperates with an amplifier (12) *via* a shielded cable (11), which amplifier is accommodated in an electrically conductive shielding box (14) comprising a bottom section and a cover section (15, 16), said unit being surrounded by a cuff-like shielding means (13) formed by the chassis (1) and strip-shaped electrically conductive walls, characterised in that the shielding box (14) for the amplifier (12) and the cuff-like shielding means (13) for the scanning unit (5) are combined to form a constructional unit in which one wall of the shielding box (14) and one wall of the cuff-like shielding means (13) are formed by a common wall portion (17).

2. An apparatus as claimed in Claim 1, characterised in that the common wall portion (17) is disposed near the free end wall of the scanning unit which is remote from the chassis (1) and extends substantially parallel to said end wall of the scanning unit (5).

3. An apparatus as claimed in Claim 2, characterised in that the common wall portion (17) is pivotably arranged on an adjoining wall (20) of the cuff-like shielding means (13).

4. An apparatus as claimed in Claim 2 or 3, characterised in that the common wall portion is formed with an opening (32) situated axially opposite the scanning unit (5), which opening allows the passage of at least the free end portion of the shaft (33) by means of which the magnetic head (8, 9) can be rotated, and an electrically conductive blade spring is arranged on and has an electrically conductive connection with that side of the common wall portion (17) which is remote from the scanning unit (5) near the opening (32) in said wall portion, the free end of said spring being in resilient contact with the free end of the shaft (33).

5. An apparatus as claimed in any one of the Claims 2 to 4, characterised in that the amplifier (12) is arranged on that side of the common wall portion (17) which is remote from the scanning unit (5), said common wall portion (17) being constructed as the bottom section of the shielding box (14) on which its cover section (16) can be placed.

6. An apparatus as claimed in any one of Claims 2 to 5, characterised in that a wall (20) of the cuff-like shielding means, which wall adjoins the common wall portion (17), is formed with a duct (31) which extends substantially parallel to the scanning unit, the shielded cable (11) *via* which the magnetic head (8, 9) cooperates with the amplifier (12) being passed through said duct.

**Revendications**

1. Appareil d'enregistrement et/ou de reproduction pour un support d'enregistrement magnétisable en forme de bande (10), qui peut être bouclé en hélice au moins sur une partie de la surface périphérique d'une unité de balayage cylindrique (5) montée sur un châssis conducteur électrique (1), ladite unité comportant au moins une tête magnétique (8, 9) pouvant être entraînée en rotation qui coopère, par l'intermédiaire d'un câble blindé (11), avec un amplificateur (12) monté dans un boîtier de blindage conducteur électrique (14) comportant une partie de fond et une partie de couvercle (15, 16), et étant entouré par une virole de blindage (13) formée par le châssis (1) et par des parois conductrices électriques en forme de bandes, caractérisé en ce que le boîtier de blindage (14) pour l'amplificateur (12) et la virole de blindage (13) pour l'unité de balayage (5) sont réunis en un module dans lequel une paroi du boîtier de blindage (14) et une paroi de la virole de blindage (13) sont formées par une partie de paroi comune (17).

2. Appareil suivant la revendication 1, caractérisé en ce que la partie de paroi commune (17) est prévue dans la zone de l'extrémité libre de l'unité de balayage qui est éloignée du châssis (1) et s'étend ainsi en substance parallèlement à la face d'extrémité de l'unité de balayage (5).

3. Appareil suivant la revendication 2, caractérisé en ce que la partie de paroi commune (17) est articulée à une paroi adjacente (20) de la virole de blindage (13).

4. Appareil suivant la revendication 2 ou 3, caractérisé en ce qu'axialement en face de l'unité de balayage (5) est prévue, dans la partie de paroi commune, une ouverture (32) traversée au moins par l'extrémité libre de l'arbre (33), par l'intermédiaire duquel la tête magnétique (8, 9) peut être entraînée en rotation, et que, du côté de la partie de paroi commune (17) qui est éloignée de l'unité de balayage (5), une lame de ressort conductrice électrique (34) est montée dans l'ouverture (32) qui y est ménagée et y est connectée électriquement, cette lame étant élastiquement en contact, par son extrémité libre, avec l'extrémité libre de l'arbre (33).

5. Appareil suivant l'une quelconque des revendications 2 à 4, caractérisé en ce que l'amplificateur (12) est monté du côté de la partie de paroi commune (17) qui est éloignée de l'unité de balayage (5), de telle sorte que cette partie de paroi commune (17) forme la partie de fond du boîtier de blindage (14) sur lequel la partie de couvercle (16) peut être posée.

6. Appareil suivant l'une quelconque des revendications 2 à 5, caractérisé en ce que, sur une paroi (20) de la virole de blindage se raccordant à la partie de paroi commune (17), est formé un canal (31) s'étendant en substance parallèlement à l'unité de balayage et livrant passage au câble blindé (11) par l'intermédiaire duquel la tête magnétique (8, 9) coopère avec l'amplificateur (12).

Fig.1

Fig.2

Fig.3

Fig.4